# EUROPEAN PATENT SPECIFICATION

(11) **EP 2 779 443 B1**
(45) Date of publication and mention of the grant of the patent: **19.07.2017**
(21) Application number: 14158853.3
(22) Date of filing: 11.03.2014
(51) Int. Cl.: H03F 3/217, H03F 1/02, H03M 1/74

(54) **All digital zero-voltage switching**
Volldigitale Nullspannungsschaltung
Commutation de tension nulle entièrement numérique

(30) Priority: 15.03.2013 US 201361799723 P; 15.03.2013 US 201361787733 P; 15.03.2013 US 201361801549 P; 19.08.2013 US 201361867233 P; 08.03.2014 US 201461201845 P
(43) Date of publication of application: 17.09.2014
(73) Proprietor: Analog Devices, Inc., Norwood, MA 02062-9106 (US)
(72) Inventor: Schafferer, Bernd, Amesbury, MA 01913 (US); Zhao, Bing, Andover, Massachusetts 01810 (US)
(74) Representative: Thompson, Andrew John

(56) References cited:
- EP-A1- 2 251 976
- WO-A1-01/10013
- US-A1- 2007 026 823
- US-A1- 2007 275 676
- MAZZANTI A ET AL: "A 1.4 GHz-2 GHz wideband CMOS class-E power amplifier delivering 23 dBm peak with 67% PAE", 2005 IEEE RADIO FREQUENCY INTEGRATED CIRCUITS (RFIC) SYMPOSIUM; 12-14 JUNE 2005; LONG BEACH, CA, USA, IEEE, PISCATAWAY, NJ, USA, 12 June 2005 (2005-06-12), pages 425-428, XP010823162, DOI: 10.1109/RFIC.2005.1489832 ISBN: 978-0-7803-8983-0

## Description

### TECHNICAL FIELD OF THE DISCLOSURE

The present disclosure is in the technical field of radio frequency (RF) power amplifiers. More particularly, the present disclosure is in the technical field of using digital to analog converters (DACs) to control a signal current in a power amplifier to optimize its power efficiency.

### BACKGROUND

Power amplifiers (PAs) have many important applications in our electronics today, one of which is the application of power amplifiers in radio frequency transmitters, where a low-power signal is amplified into a larger signal of significant power for driving an antenna of a transmitter. Power amplifiers are one of the weakest links in the transmit signal chain. Many new PA architectures have been developed or rediscovered over the last years to improve the linearity, efficiency, bandwidth, and output power.

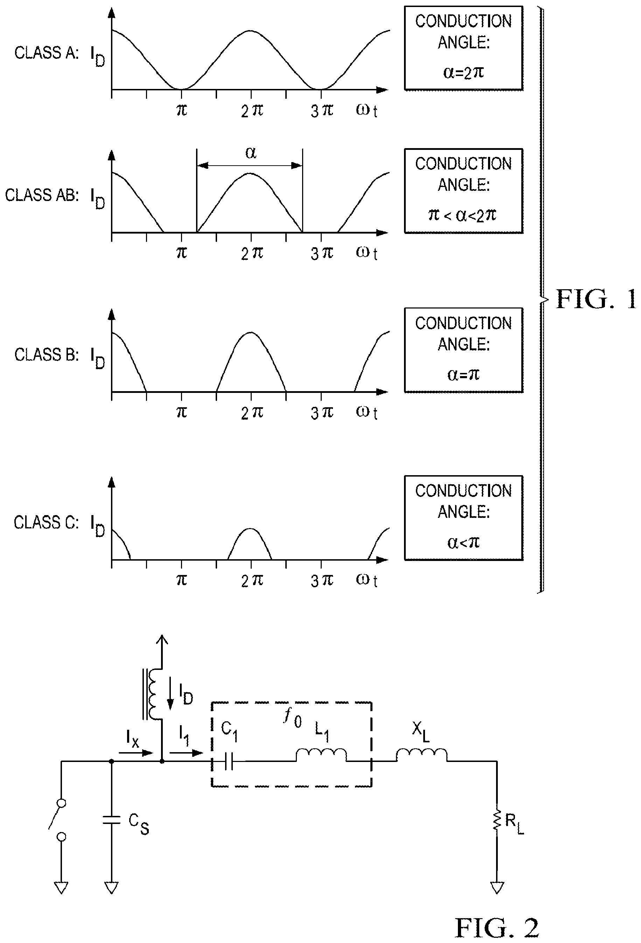

Power amplifiers have many classes, such as Class A, AB, B, C, E, or F amplifiers. Class A power amplifiers are the least efficient. Power amplifiers use Class AB, B or C configurations where the power driving transistor is on for a smaller fraction respectively of the complete cycle compared to class A, to improve efficiency. FIGURE 1 shows illustrative current waveforms for Class A, AB, B, and C amplifiers. These amplifiers' efficiency depends heavily on the control of the current waveform with respect to the voltage waveform in order to minimize power dissipation. However, solutions for controlling the current waveform have been insufficient to achieve optimal efficiency.

### OVERVIEW

Power efficiency is an important design requirement of power amplifiers. To improve power efficiency, a solution proposed in this present disclosure includes an all-digital zero-voltage switching apparatus for directly driving a switching power amplifier through a desired current pulse shape. The apparatus includes a digital engine and a digital-to-analog converter (DAC). The digital engine processes baseband data and generates a digital output. The digital output of the digital engine drives the DAC to generate a digitally controlled current output having that desired current pulse shape. The digitally controlled current output is used to directly drive the switch power amplifier to improve power efficiency. The digitally controlled current output comprising digitally generated current pulses is controlled accurately by the digital engine and the DAC, and thus allows the switching power amplifier to operate optimally with higher power efficiency than conventional power amplifiers. Thus efficiency may be improved or even optimized.

Documents US 2007/275676 and "A 1.4 GHz-2 GHz wideband CMOS class-E power amplifier delivering 23 dBm peak with 67% PAE" by A. Mazzanti , L. Larcher, R. Brama, F. Svelto published in Radio Frequency integrated Circuits (RFIC) Symposium, 2005. Digest of Papers. 2005 IEEE, are examples of power amplifiers with improved efficiency.

### BRIEF DESCRIPTION OF THE DRAWINGS

FIGURE 1 shows illustrative current waveforms for Class A, AB, B, and C amplifiers;
FIGURE 2 shows an illustrative Class E power amplifier modeled as a switch, according to some embodiments of the disclosure;
FIGURE 3A shows an illustrative Class F power amplifier with odd harmonic blocking filters, according to some embodiments of the disclosure;
FIGURE 3B shows illustrative voltage waveforms and an exemplary current waveform of a Class F power amplifier, according to some embodiments of the disclosure;
FIGURE 4 shows a system for driving a power amplifier;
FIGURE 5 shows illustrative waveforms which conventional digital-to-analog converters can generate;
FIGURE 6 shows illustrative waveforms used in a power efficient power amplifier, according to some embodiments of the disclosure;
FIGURE 7 shows an improved system for driving a power amplifier, according to some embodiments of the disclosure;
FIGURE 8 shows illustrative voltage waveforms, an illustrative desired shape for the current waveform, and an illustrative digitally controlled current output, according to some embodiments of the disclosure;
FIGURE 9 shows exemplary implementations of an improved system for driving a power amplifier, according to some embodiments of the disclosure;
FIGURE 10 shows an exemplary implementation of an improved system for driving a power amplifier, according to some embodiments of the disclosure;
FIGURE 11 shows an exemplary flow diagram illustrating a method for using one or more digital to analog converters (DACs) to optimize power efficiency of the switching power amplifier through zero-voltage switching, according to some embodiments of the disclosure;
FIGURE 12 shows an exemplary transmitter system having an improved system for driving a power amplifier, according to some embodiments of the disclosure; and
FIGURE 13 shows an exemplary transmitter system having an improved system for driving a power amplifier, according the some embodiments of the disclosure.

### DESCRIPTION OF EXAMPLE EMBODIMENTS OF THE DISCLOSURE

### Understanding power efficiency of power amplifiers and zero-voltage switching

Further improvements to power efficiency of a power amplifier are possible using Class E and F configurations where the power driving transistor is operated as a switch. FIGURE 2 shows an illustrative Class E power amplifier modeled as a switch. A switch has low resistance impedance when closed and a high resistance when open. If the switch (i.e., the driving transistor) is turned on, the output voltage is near zero. Therefore maximum current flows through the switch with very little voltage across it. Conversely, if the switch is turned off, the output voltage is high. Therefore no or minimal current flows through the switch with high voltage across it. In both cases the switch power dissipation is minimal, optimizing efficiency.

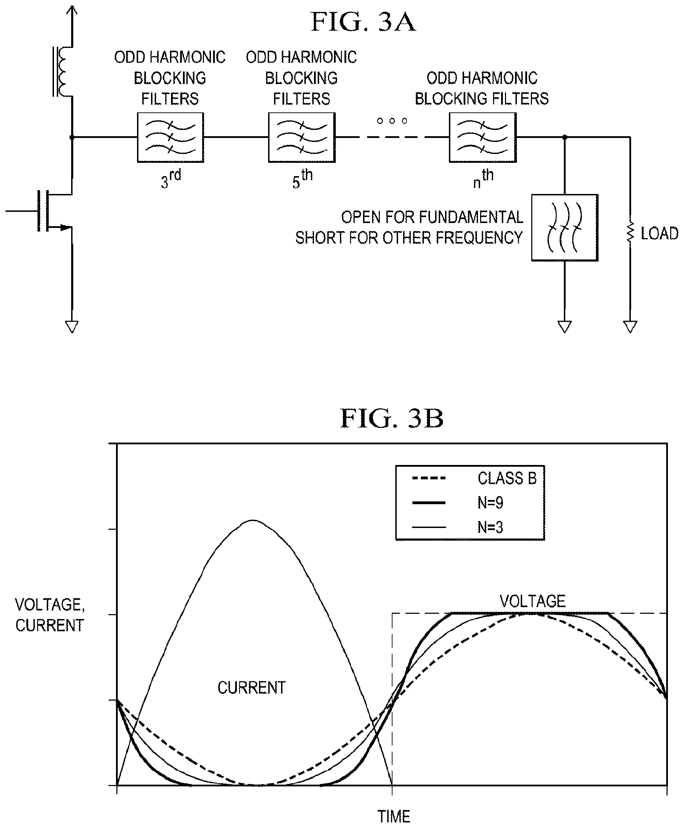

In practice, Class E amplifiers have power efficiency limitations due to the overlap of the current and voltage waveforms where the power is dissipated by the transistor. The lack of proper control over the current waveform may further exacerbate the power dissipation issue. Class F amplifiers can further improve on this overlap. FIGURE 3A shows an illustrative Class F power amplifier with odd harmonic blocking filters, according to some embodiments of the disclosure. These illustrative harmonic blocking filters allow the voltage to assemble the square waveform to reduce the amount of overlap between the voltage and current waveforms. FIGURE 3B shows illustrative voltage waveforms and an exemplary current waveform of a Class F power amplifier, according to some embodiments of the disclosure. By adding filters that block the odd harmonic from getting to the load, peaking back at the drain makes the waveform more square (e.g., flatter at the peak maximums and minimums of the waveform), reducing the voltage current waveform overlap and thereby improving power efficiency.

### Example system for driving the power amplifier and its inefficacies

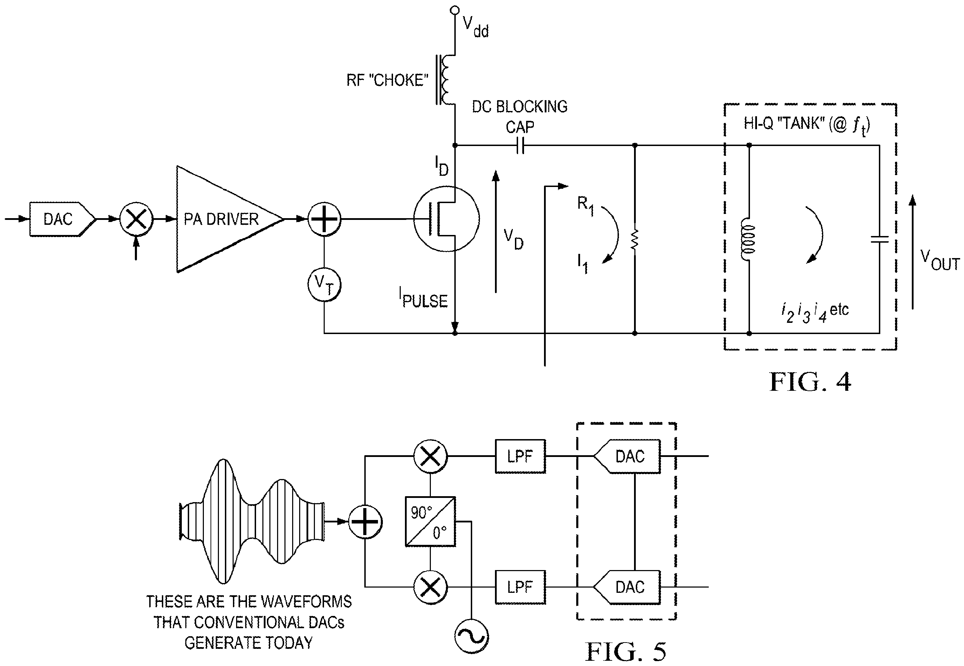

To drive a power amplifier with these waveforms, typically a high speed digital-to-analog converter (DAC) is used to drive the input of an amplifier configured in any of the variety of Classes of amplifiers. For instance, the DAC can be used to turn on the gate voltage of the switching transistor of the class F power amplifier, and hence the drain voltage is low and the current is highest for optimal power dissipation. FIGURE 4 shows such a system for driving a power amplifier. The system requires an intermediate current to voltage conversion stage for the quadrature modulator interface. This requirement can increase the system complexity and inefficiency. Furthermore, having the current to voltage conversion increases the number of components and power consumption of the entire system.

### Waveforms generated by digital-to-analog converters (DACs) and shapes of signal waveforms

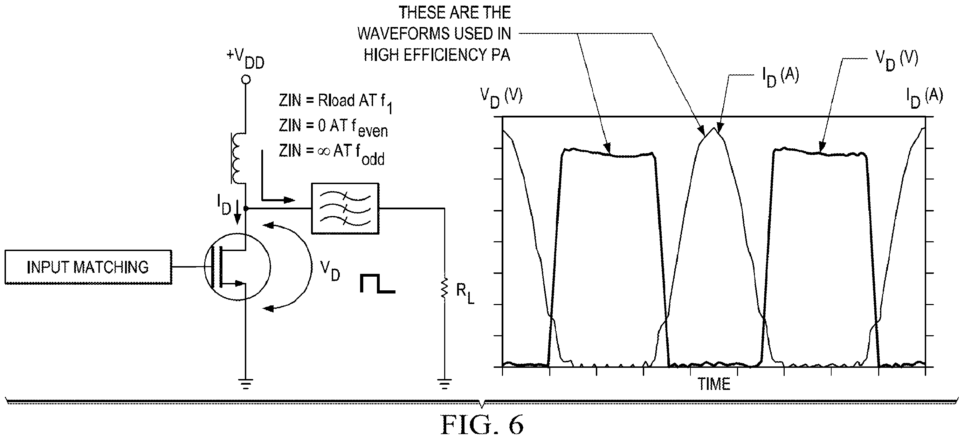

FIGURE 5 shows illustrative waveforms which conventional digital-to-analog converters (DACs) can generate. DACs typically drives spectrally pristine radio-frequency signals, depicted in FIGURE 5, and the signals need to be reshaped to improve the power amplifier (PA) performance. FIGURE 6 shows illustrative waveforms used in a power efficient power amplifier, according to some embodiments of the disclosure. The desirable signals driving a PA with high efficiency and linearity, depicted in FIGURE 6, look very different than the signals that are produced by DACs in the existing system. The system and method according to the independent claims of the present disclosure can efficiently bridge the gap/difference.

### An improved system: all digital zero-voltage switching (ZVS)

To provide the desirable signals and respective shapes of signal waveforms (as shown in FIGURE 6), an all-digital ZVS system is used to simultaneously optimize PA linearity and efficiency while achieving large bandwidth. An all-digital ZVS system improves upon the transmit architecture shown in FIGURE 4. Specifically, the improved solution provides full digital control over the shape of the current pulse into the power amplifier to optimize the power efficiency of the radio frequency conversion. Moreover, the improved solution involves a high efficiency power amplifier with digitally generated current output comprising current pulses from a digital-to-analog converter (DAC) to improve the efficiency of the RF conversion.

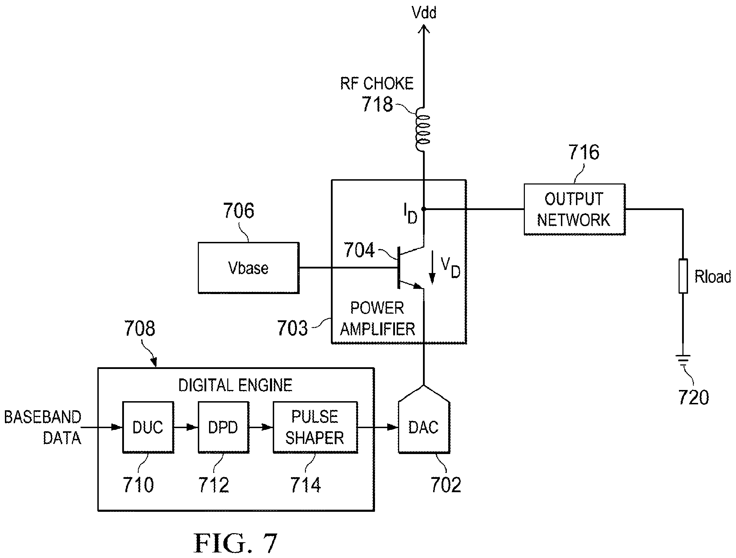

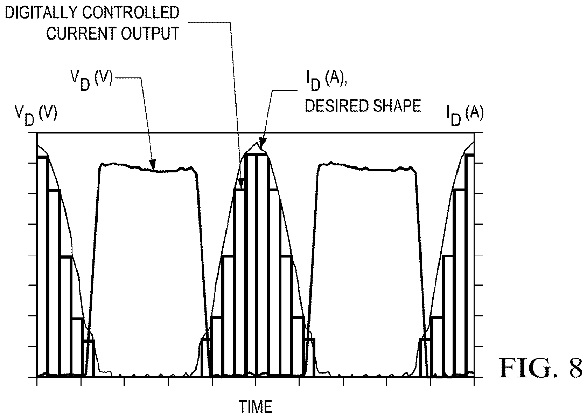

FIGURE 7 shows an improved system for driving a power amplifier, according to some embodiments of the disclosure. The system includes an apparatus which uses one or more digital to analog converters (DACs) 702 to optimize power efficiency of a switching power amplifier 703 through zero-voltage switching. As shown, the switching power amplifier 703 is modeled as a switch having driving transistor 704. Vbase 706 (e.g., a module for providing a base voltage, or referred herein as the base voltage generator) is connected to the base of the transistor 704, and the drain current is denoted as I_{D} and the voltage across the transistor 704 is denoted as V_{D}. The desired signal waveforms for I_{D} and V_{D} in this system may correspond to exemplary waveforms of I_{D} (A) and V_{D} (V) of FIGURE 6 (which is also shown in FIGURE 8 in a later part of the present disclosure) for achieving zero-voltage switching to improve power efficiency.

The apparatus includes a DAC 702 having a digitally controlled current output driving the switching power amplifier 703, wherein the digitally controlled current output of the DAC 702 is connected to an emitter of a driving transistor 704 of the switching power amplifier 703. This configuration equates to a common base configuration for a bipolar transistor being used as the driving transistor, or equivalently, this configuration equates to a common gate configuration for a (Metal-Oxide-Semiconductor) field-effect transistor as the driving transistor (wherein the digitally controlled current output would be connected to the source of the driving transistor). By controlling the emitter current, the digitally controlled current output allows I_{D} to be controlled as well. The DAC 702 operates at a high sample rate, e.g., in the gigahertz range, such that the desired current pulse shape of the emitter and collector current can be more accurately controlled. When the switching amplifier is on, the emitter/collector current is high and the voltage across the transistor is low, as a result, the power dissipation of the power amplifier can be minimized.

The apparatus further includes a digital engine 708 which receives a baseband signal input and provides a digital output driving an input of the DAC 702 for the DAC 702 to output a digitally controlled current output having a (desired) switching waveform. In other words, the DAC 702 is controlled by the digital output of the digital engine in order to allow the DAC to generate a suitable digitally controlled current output, i.e., shape the current output of the DAC to have a proper magnitude with respect to the voltage across the transistor 704 for improving power efficiency.

The resulting apparatus comprises a DAC 702 and a digital engine 708 (and any suitable components therein), which provide the all-digital control over the current flowing through the power amplifier, thereby providing an all-digital ZVS system. The all-digital ZVS system provides several advantages. One advantage includes eliminating the current to voltage conversion stage that is necessary in the conventional architecture. Effectively, the all-digital ZVS system allows the DAC 702 to drive the switching power amplifier (directly) in the absence of a current to voltage conversion stage. Using a DAC 702 to directly generate the signal that is desired in a high efficiency power amplifier removes the intermediate current to voltage conversion stage for the quadrature modulator interface. It reduces the interface inefficiency and the design complexity. It also reduces the power consumption and the component counts of the system and achieves higher integration level in the transmit signal chain. Another advantage results from using an all-digital engine for providing the digitally controlled signal output. To achieve higher power efficiency, it is critical to define the shape of current and voltage to minimize the overlap of the voltage and current in the power amplifier and therefore to minimize the power dissipation in the active device. Using a DAC 702 to digitally control the shape of the current pulses of the digitally controlled current output, more abrupt transitions at the transistor turn-on and turn-off are possible with more design flexibility. The accuracy of the representation of the current pulses may be affected by the DAC speed and resolution.

### Desired voltage waveform, current waveform, and switching waveform

FIGURE 8 shows illustrative voltage waveforms, an illustrative desired shape for the current waveform, and an illustrative digitally controlled current output, according to some embodiments of the disclosure. The illustrative voltage waveform V_{D} (V) resembles the desired waveform for a Class F power amplifier. When the power amplifier is on, the voltage is zero (or close to zero) and the current is drawn from the emitter according to the desired shape of the current waveform I_{D} (A). The bars shown according to the desired shape represents an exemplary set of current pulses (of a switching waveform) for the digitally controlled current output produced by the all-digital ZVS switching system of the present disclosure for improving power efficiency of the power amplifier. Specifically, the switching waveform comprises uniformly spaced current pulses having various magnitudes (e.g., to match a desired current waveform). The spacing of the pulses (e.g., the width of the pulses) depends on the speed of the DAC 702. In one example, the width of the pulses can be in the order of tens of picoseconds. The uniformly spaced current pulses comprises pulses having a magnitude according to a pulse shape (e.g., the pulse shape of the current waveform I_{D} (A)) when the switching power amplifier is turned on and a voltage across the driving transistor is at a minimal level (e.g., V_{D} (V) is below a low voltage threshold, near zero, and/or zero), and pulses having-no magnitude (or close to zero) when the switching power amplifier is turned off (e.g., when V_{D} (V) is high and/or above a low voltage threshold).

### Digital engine, power amplifier, output network, and load for the improved system

Referring back to FIGURE 7, the digital engine 708 may include one or more of the following: a digital up conversion (DUC) module 710, a digital pre-distortion (DPD) module 712, and a pulse shaper 714. While all three components are shown, its connections (e.g., manner of connecting the components) and selection of one or more of these components may vary depending on the application. For instance, a variation of the system may include the DPD module 712 before the DUC module 710 and the pulse shaper 714. A baseband signal passes through the components in the digital engine 708 and the output of the digital engine 708 is fed as input to the DAC 702 to drive the DAC 702. The digital engine 708 together with the DAC 702 drives the power amplifier 704 and controls the current shape.

The up conversion, DUC module 710, is done entirely in the digital domain and can take advantage of the advanced technology node, for example, 28nm process, to reduce the system power consumption. It eliminates the phase-locked loop (PLL), Voltage Controlled Oscillator (VCO) and modulator from the signal chain and avoid problems present in zero intermediate frequency (ZIF) or complex intermediate frequency (CIF) architecture, like the quadrature error correction, and Local Oscillator (LO) feed through.

The DPD module 712 may compensate for the non-ideal performance caused by the nonlinearities of the DAC and the (cascode) power amplifier. The inclusion of a DPD module further improves the efficiency of the power amplifier by running these components in their non-linear regions.

The pulse shaper 714 includes a wave shaping network. It can be an algorithm which takes the linear input signal and maps it to an output sequence which delivers the correct amount of energy to the output network. By doing this, the energy loss over the power transistor is kept at minimum.

The power amplifier 703 can be any of the switched-mode power amplifiers, for example, a class E or F configuration. The power amplifier may comprise a cascode stage in a common base configuration using high breakdown voltage compound semiconductor materials, and the digitally controlled current output from the DAC 702 has a current on the order of hundreds of milliamps (e.g., above 100 milliamps, between 100 milliamps to 512 milliamps, or more). With the cascode configuration, the emitter voltage can be kept low enough to not exceed the voltage tolerance of the advanced process the DAC may be built on. Using high breakdown voltage compound semiconductor materials such as GaN or GaAs, high collector voltages are possible allowing for the high current of the DAC (on the order of hundreds of milliamps) along with high collector voltage swings to generate large amounts of power from the power device. The power amplifier 703 can include a single structure or multiple parallel structures.

The output network 716 includes a matching network and any possible harmonic tuning networks to control the harmonic contents and resemble the square waveform of the collector voltage (such as one used in Class F operation). The apparatus may include one or more resonator output filters associated with a class F operation. The resonator output filter controls the harmonic content of the collector voltage and/or current, by shaping the waveforms to reduce the power dissipated on the active transistor 704. This in turn increases the-power amplifier efficiency.

The radio frequency choke 718 is connected between the power amplifier and the power supply to allow the DC current to flow through the transistor. Rload 720 represents the loading network. Rload 720 can be the actual load impedance, or possibly the impedance of the input-port of the filter following the power amplifier 716.

### Exemplary Implementations of the digital-to-analog converter for the improved system

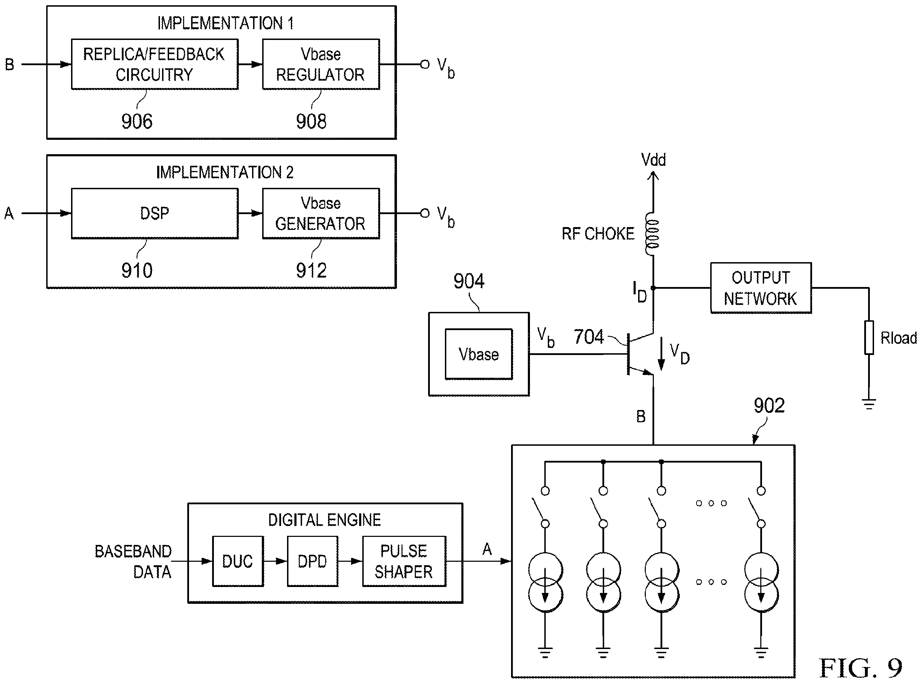

Various implementations are possible for providing DAC 702 as seen in FIGURE 7. FIGURE 9 shows the implementation of an improved system for driving a power amplifier, according to some embodiments of the disclosure, where the DAC 902 can be implemented in different ways. For example, the DAC may include switch arrays, and output impedance control of switches in the switch arrays controls the magnitudes of the digitally controlled current output. In some examples, the DAC may include current source arrays configurable to provide varying magnitudes of the digitally controlled current output based on the digital output of the digital engine. In some examples, the DAC comprises resistor arrays configurable to provide varying magnitudes of the digitally controlled current output based on the digital output of the digital engine.

In some examples, the DAC comprises current source arrays and resistor arrays. The current source arrays convert most significant bits of the digital output signal (from the digital engine) and the resistor arrays convert least significant bits of the digital output signal (from the digital engine). They are combined to provide the digitally controlled current output of the DAC. In another example of a segmented DAC design, the DAC comprises switch arrays and resistor arrays.

Generally speaking, the DAC for producing precision current pulses to directly drive the driving transistor of the power amplifier should operate at a very high speed (in the gigahertz range) in order to extract the input modulation information accurately. For this reason, it is preferred that the DAC is implemented using current steering DACs, and not implemented with capacitor arrays which are far slower than current steering DACs.

In one embodiment, the DAC 702 can be implemented with parallel DAC structures, where the DAC structures are duplicated to achieve large output current. The DAC 702 may be a DAC system comprising four, six, or eight (or even more) parallel DAC cores. The same input word may be provided as the digital input signal to the parallel DAC cores, and the outputs from the DAC cores may be combined to provide an aggregate analog output having a current output on the order of hundreds of milliamps. The outputs of the DACs are amplified and combined in a cascode stage of the switching power amplifier 703. The cascode stage may include eight (or more) parallel cascodes directly connected to the eight parallel DAC cores. The cascode stage may include a power combining network to combine the output power at the outputs of the cascodes.

It is envisioned that a combination of these technologies can be used to provide the architecture of the DAC in a segmented design where certain bits of the input word is converted into an analog signal using one of these exemplary implementations, and other bits of the input word is converted into an analog signal using another one of these exemplary implementations.

### Providing a suitable voltage waveform at the base/gate of the driving transistor

Besides providing a suitable current waveform, the driving transistor is also driven with a proper voltage waveform at the base of the driving transistor (or gate, if a field-effect transistor is used). An illustrative waveform for the voltage works in tandem with an illustrative waveform for the current (in some ways dependent on each other), as seen in FIGURE 8, to provide zero-voltage switching. Referring back to FIGURE 9, different implementations are possible for providing a base voltage generator 904 to provide a base voltage having the desired voltage waveform for the driving transistor. The base voltage generator (labeled as "Vbase") 904 bias circuitry can be implemented in various ways.

In some cases, the base voltage generator 904 can use a Vbase regulator 908 to provide the base voltage. The Vbase regulator 908 closes the loop with a replica module 906 (or feedback current branch) mirrored from the main current path B. In this example, the base voltage generator comprises a replica module 906 connected to the digitally controlled current output of the DAC, for mirroring the digitally controlled current output, and a voltage regulator (Vbase regulator 908), connected to the output of the replica module, for generating a base voltage according to the voltage waveform based on the output of the replica module.

In some cases, the signal processed by the digital engine (of signal path A) can go through a digital signal processor (DSP) 910 (having some suitable DSP functions) and drive a Vbase generator 912 to provide the gate control signals. In this case, the input modulation information presents in both the DAC current and the Vbase voltage at the same time. The base voltage generator can include a digital signal processor 910 connected the digital output of the digital engine for processing the digital output to generate voltage information according to the voltage waveform at the output of the digital signal processor, and a voltage generator (Vbase generator 912), connected to the output of the digital signal processor module, for generating the base voltage based on the voltage information.

### An improved system: multi-carrier transmitter

Wide dynamic range and excellent linearity are typical requirements for DACs to be used in multi-carrier scenarios at high frequency. In these scenarios, the signal generation circuitry, i.e., a DAC, and the power amplification circuitry, i.e., the power amplifier, are integrated together to achieve high output drive capability and boost the dynamic range. At the same time, frequency domain or time domain build-in DPD can be applied to improve the linearity of the system. As a result, the improved system is advantageous in constructing the multi-carrier transmitter.

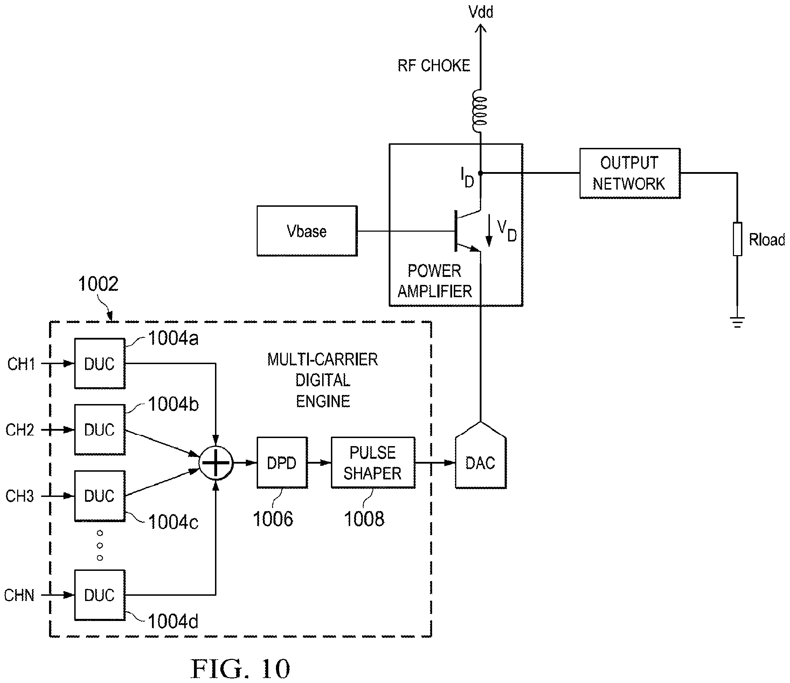

FIGURE. 10 depicts a multi-carrier digital engine 1002 as part of an exemplary implementation of an improved system for driving a power amplifier. The digital frequency tuning ability in the multiple digital up-conversion blocks (e.g., DUC 1004a, 1004b, 1004c, and 1004d, and could have more depending on the number of channels) mix the individual carriers at different frequencies and the digital intermediate frequencies are summed together (e.g., through a summation node) to generate the multi-carrier signal. After having the multi-carrier signal go through DPD 1006 and pulse shaper 1008, the output signal of the multi-carrier digital engine 1002 then goes through a single DAC/power amplifier system to generate the desired output signal. In this system, one single transmitter is able to the replace multiple single-carrier transmitters. It simplifies the system design, greatly reduces the power consumption, and provides tremendous design flexibility.

### An Improved method: all-digital ZVS

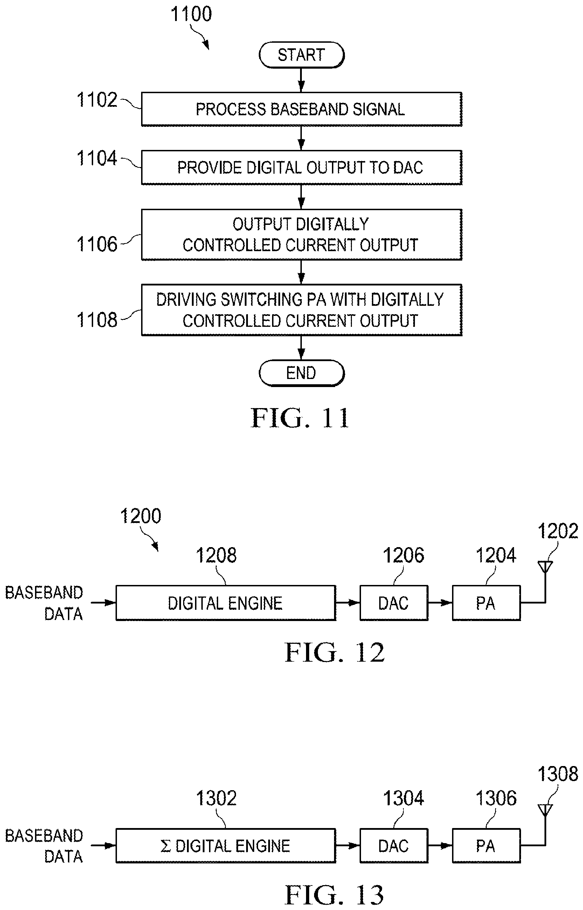

FIGURE 11 shows an exemplary flow diagram illustrating a method for using one or more digital to analog converters (DACs) to optimize power efficiency of the switching power amplifier through zero-voltage switching, according to some embodiments of the disclosure. The method 1100 comprises processing a baseband signal as input by a digital engine (box 1102), providing a digital output of the digital engine to drive an input of the DAC (box 1104), outputting, by the DAC, a digitally controlled current output having a switching waveform (box 1106), driving the switching power amplifier directly with the digitally controlled current output of the DAC (box 1108). The digitally controlled current output of the DAC is connected to an emitter of a driving transistor of the switching power amplifier.

In particular, the switching waveform of the digitally controlled current output (related to box 1106 and 1108) comprises uniformly spaced current pulses having various magnitudes (e.g., the magnitudes being provided according to a desired current waveform). Furthermore, outputting, by the DAC, the digitally controlled current output (box 1106) may comprise outputting pulses having a magnitude according to a pulse shape when the switching power amplifier is turned on and a voltage across the driving transistor is at a minimal level and outputting pulses having little to no magnitude when the switching power amplifier is turned off.

In some cases, outputting, by the DAC, the digitally controlled current output (box 1106) comprises outputting a current on the order of hundreds of milliamps to the power amplifier comprising a cascode stage in a common base configuration using high breakdown voltage compound semiconductor materials.

In some cases, processing the baseband signal by the digital engine comprises filtering the baseband signal through one or more of the following: a digital up conversion module, a digital pre-distortion module, and a pulse shaper.

In some cases, driving the switching power amplifier directly with the digitally controlled current output (box 1108) comprises driving the switching power amplifier using the digitally controlled current output in the absence of a current to voltage conversion stage.

### Example transmitters having an improved ZVS system

FIGURE 12 shows an exemplary transmitter system 1200 having an improved system for driving a power amplifier, according to some embodiments of the disclosure. The transmitter having antenna 1202 may further include the improved system. The improved system includes a switching power amplifier 1204. Furthermore, the improved system includes a digital to analog converter 1206 having a digitally controlled current output driving the switching power amplifier, wherein the digitally controlled current output of the DAC 1206 is connected to an emitter of a driving transistor of the (switching) power amplifier 1204. Moreover, the improved system includes a digital engine 1208 receiving a baseband signal input and providing a digital output driving an input of the DAC 1204. The DAC outputs the digitally controlled current output having a switching waveform, based on the digital output driving the input of the DAC. The output signal produced by the power amplifier 1204 is provided to the antenna 1202 for transmission.

In the wireless infrastructure market, there have been constant battles in order to increase the dynamic range and frequency range of the transmitter. The proposed methods and systems brings the technology one step further towards the Bit2RF system, which directly translates the digital bits to the radio frequency signal in the transmit path. It simultaneously achieves higher output drive capability, wider frequency range, and higher power efficiency. It can be especially suitable in the distributed antenna system networks, i.e., the active antenna and small cell systems.

FIGURE 13 shows yet another exemplary transmitter system having an improved system for driving a power amplifier. Namely, the improved system has a multi-carrier digital engine 1302, a variant of the digital engine. As previously discussed in relation to FIGURE 10, the improved systems and methods can work particularly well in multi-carrier scenarios at high frequency. Using the implementation shown in FIGURE 10, a single transmitter is able to the replace multiple single-carrier transmitters. It simplifies the system design, greatly reduces the power consumption, and provides tremendous design flexibility.

As shown in FIGURE 13, the improved transmitter system includes the multi-carrier digital engine 1302, a digital to analog converter (DAC) 1304, a (switching) power amplifier 1306, and an antenna 1308. The DAC 1304 has a digitally controlled current output driving the (switching) power amplifier 1306, wherein the digitally controlled current output of the DAC 1304 is connected to an emitter of a driving transistor of the switching power amplifier 1306. Moreover, the improved system includes the multi-carrier digital engine 1302 receiving a baseband signal input and providing a digital output driving an input of the DAC 1304. The DAC outputs the digitally controlled current output having a switching waveform based on the digital output driving the input of the DAC 1304. The output signal produced by the power amplifier 1306 is provided to the antenna 1308 for transmission.

The multi-carrier digital engine 1302 can be implemented the same way as shown in FIGURE. 10. For instance, the digital engine may include one or more of the following: a plurality of digital up conversion blocks, each of the digital up conversion blocks for mixing individual carriers at different frequencies to generate digital intermediate frequencies, a summation node for summing the digital intermediate frequencies to generate a multi-carrier signal, a digital pre-distortion module taking the multi-carrier signal as input for generating a pre-distorted signal, and a pulse shaper taking pre-distorted signal as input to generate the digital output of the digital engine.

### Exemplary implementations and variations

In the discussions of the embodiments above, the capacitors, clocks, DFFs, dividers, inductors, resistors, amplifiers, switches, digital core, transistors, and/or other components can readily be replaced, substituted, or otherwise modified in order to accommodate particular circuitry needs. Moreover, it should be noted that the use of complementary electronic devices, hardware, software, etc. offer an equally viable option for implementing the teachings of the present disclosure. The choice of transistors and current sinking vs current sourcing DACs illustrated here are not meant to limit the choice of circuit topology.

In one example embodiment, any number of electrical circuits of the FIGURES may be implemented on a board of an associated electronic device. The board can be a general circuit board that can hold various components of the internal electronic system of the electronic device and, further, provide connectors for other peripherals. More specifically, the board can provide the electrical connections by which the other components of the system can communicate electrically. Any suitable processors (inclusive of digital signal processors, microprocessors, supporting chipsets, etc.), memory elements, etc. can be suitably coupled to the board based on particular configuration needs, processing demands, computer designs, etc. Other components such as external storage, additional sensors, controllers for audio/video display, and peripheral devices may be attached to the board as plug-in cards, via cables, or integrated into the board itself.

In another example embodiment, the electrical circuits of the FIGURES may be implemented as stand-alone modules (e.g., a device with associated components and circuitry configured to perform a specific application or function) or implemented as plug-in modules into application specific hardware of electronic devices. Note that particular embodiments of the present disclosure may be readily included in a system on chip (SOC) package, either in part, or in whole. An SOC represents an IC that integrates components of a computer or other electronic system into a single chip. It may contain digital, analog, mixed-signal, and often radio frequency functions: all of which may be provided on a single chip substrate. Other embodiments may include a multi-chip-module (MCM), with a plurality of separate ICs located within a single electronic package and configured to interact closely with each other through the electronic package. In various other embodiments, the amplification functionalities may be implemented in one or more silicon cores in Application Specific Integrated Circuits (ASICs), Field Programmable Gate Arrays (FPGAs), and other semiconductor chips.

It is also imperative to note that all of the specifications, dimensions, and relationships outlined herein (e.g., the number of processors, logic operations, etc.) have only been offered for purposes of example and teaching only. Such information may be varied considerably without departing from the scope of the appended claims. The specifications apply only to one non-limiting example and, accordingly, they should be construed as such. In the foregoing description, example embodiments have been described with reference to particular processor and/or component arrangements. Various modifications and changes may be made to such embodiments without departing from the scope of the appended claims. The description and drawings are, accordingly, to be regarded in an illustrative rather than in a restrictive sense.

In certain contexts, the features discussed herein can be applicable to radio frequency wireless communications, radar, audio and video equipment, base stations, transmitters, and other digital-processing-based systems which may benefit from a power efficient power amplifier driven directly by a DAC.

### Other notes, examples, and implementations

Note that all optional features of the apparatus described above may also be implemented with respect to the method or process described herein and specifics in the examples may be used anywhere in one or more embodiments.

In a first example, a system is provided (that can include any suitable circuitry, dividers, capacitors, resistors, inductors, ADCs, DFFs, logic gates, software, hardware, links, etc.) that can be part of any type of computer, which can further include a circuit board coupled to a plurality of electronic components. The system can include means for clocking data from the digital core onto a first data output of a macro using a first clock, the first clock being a macro clock; means for clocking the data from the first data output of the macro into the physical interface using a second clock, the second clock being a physical interface clock; means for clocking a first reset signal from the digital core onto a reset output of the macro using the macro clock, the first reset signal output used as a second reset signal; means for sampling the second reset signal using a third clock, which provides a clock rate greater than the rate of the second clock, to generate a sampled reset signal; and means for resetting the second clock to a predetermined state in the physical interface in response to a transition of the sampled reset signal.

The 'means for' in these instances (above) can include (but is not limited to) using any suitable component discussed herein, along with any suitable software, circuitry, hub, computer code, logic, algorithms, hardware, controller, interface, link, bus, communication pathway, etc. In a second example, the system includes memory that further comprises machine-readable instructions that when executed cause the system to perform any of the activities discussed above.

## Claims

1. An apparatus adapted to control a switching power amplifier (703) through zero-voltage switching, comprising:
a DAC (702) having a digitally controlled current output driving the switching power amplifier, wherein the digitally controlled current output of the DAC is connected to an emitter of a driving transistor (704) of the switching power amplifier; and
a digital engine (708) adapted to receive a baseband signal input, configured for up converting the baseband signal input to a radio frequency (RF) digital output and for providing the RF digital output driving an input of the DAC for the DAC to output a digitally controlled current output having a switching waveform.

2. The apparatus of Claim 1, wherein the switching waveform comprises uniformly spaced current pulses having various magnitudes, wherein the uniformly spaced current pulses comprises:
pulses having a magnitude according to a desired current pulse shape when the switching power amplifier is turned on and a voltage across the driving transistor is at a minimal level; and
pulses having little to no magnitude when the switching power amplifier is turned off.

3. The apparatus of Claim 1 or 2, wherein at least one of the following apply:
a) the power amplifier comprises a cascode stage in a common base configuration using high breakdown voltage compound semiconductor materials; and the digitally controlled current output has a current on the order of hundreds of milliamps;
b) wherein the switching power amplifier includes an amplifier having a class E or F configuration

4. The apparatus of Claim 1, 2 or 3 further comprising:
one or more resonator output filters associated with a class F operation, wherein a voltage waveform at the collector approaches a square waveform to reduce additional power dissipation.

5. The apparatus of any preceding Claim, wherein at least one of the following applies:
a) the DAC comprises switch arrays, and output impedance control of switches in the switch arrays is adapted to control the magnitudes of the digitally controlled current output;
b) the DAC comprises resistor arrays configurable to provide varying magnitudes of the digitally controlled current output based on the digital output of the digital engine.

6. The apparatus of any preceding Claim, wherein the DAC is adapted to drive the switching power amplifier using the digitally controlled current output in the absence of a current to voltage conversion stage.

7. The apparatus of any preceding Claim, further comprising a base voltage generator to provide a base voltage for the driving transistor having a voltage waveform, wherein the base voltage generator comprises:
a) a replica module connected to the digitally controlled current output of the DAC for mirroring the digitally controlled current output and a voltage regulator connected to the output of the replica module for generating a base voltage according to the voltage waveform based on the output of the replica module; or
b) a digital signal processor connected the digital output of the digital engine for processing the digital output to generate voltage information according to the voltage waveform at the output of the digital signal processor, and a voltage generator connected to the output of the digital signal processor for generating the base voltage based on the voltage information.

8. The apparatus of any preceding Claim, wherein the digital engine comprises one or more of the following: a digital up conversion module, a digital pre-distortion module, and a pulse shaper.

9. The apparatus of any preceding Claim, wherein the digital engine comprises:
a plurality of digital up conversion blocks, each of the digital up conversion blocks for mixing individual carriers at different frequencies to generate digital intermediate frequencies.

10. The apparatus of Claim 9, wherein the digital engine further comprises:
a summation node for summing the digital intermediate frequencies to generate a multi-carrier signal.

11. The apparatus of Claim 10, wherein the digital engine further comprises:
a digital pre-distortion module taking the multi-carrier signal as input for generating a pre-distorted signal; and
a pulse shaper taking pre-distorted signal as input to generate the digital output of the digital engine.

12. A radio frequency transmitter system for driving an antenna, said antenna configured to transmitting radio frequency signals, comprising:
a switching power amplifier for producing the radio frequency signals to be transmitted by the antenna, and an apparatus as claimed in any preceding claim.

13. A method for using one or more digital to analog converters (DACs) to optimize power efficiency of the switching power amplifier through zero-voltage switching, comprising:
processing a baseband signal as input by a digital engine, the processing comprising up converting the baseband signal to a radio frequency (RF) digital output of the digital engine;
providing the RF digital output of the digital engine to drive an input of the DAC;
outputting, by the DAC, a digitally controlled current output having a switching waveform; and
driving the switching power amplifier directly with the digitally controlled current output of the DAC, wherein the digitally controlled current output of the DAC is connected to an emitter of a driving transistor of the switching power amplifier.

14. The method of Claim 13, wherein:
the switching waveform comprises uniformly spaced current pulses having various magnitudes;
outputting, by the DAC, the digitally controlled current output comprises:
outputting pulses having a magnitude according to a pulse shape when the switching power amplifier is turned on and a voltage across the driving transistor is at a minimal level; and
outputting pulses having little to no magnitude when the switching power amplifier is turned off.

15. The method of Claim 13 or 14 where at least one of the following applies:
a) outputting, by the DAC, the digitally controlled current output comprises outputting a current on the order of hundreds of milliamps to the power amplifier comprising a cascode stage in a common base configuration using high breakdown voltage compound semiconductor materials;
b) driving the switching power amplifier directly with the digitally controlled current output comprises driving the switching power amplifier using the digitally controlled current output in the absence of a current to voltage conversion stage.

## Patentansprüche

1. Vorrichtung, die ausgelegt ist, durch Nullspannungsschalten einen Schaltleistungsverstärker (703) zu steuern, die Folgendes umfasst:
einen DAC (702), der einen digital gesteuerten Stromausgang aufweist, der den Schaltleistungsverstärker ansteuert, wobei der digital gesteuerte Stromausgang des DAC mit einem Emitter eines Ansteuertransistors (704) des Schaltleistungsverstärkers verbunden ist; und
eine digitale Maschine (708), die ausgelegt ist, einen Basisbandsignaleingang zu empfangen, die zum Aufwärtsumsetzen des Basisbandsignaleingangs in einen digitalen Funkfrequenzausgang (HF-Ausgang) und zum Bereitstellen des digitalen HF-Ausgangs, der einen Eingang des DAC ansteuert, damit der DAC einen digital gesteuerten Stromausgang ausgibt, der eine Schaltwellenform aufweist, konfiguriert ist.

2. Vorrichtung nach Anspruch 1, wobei die Schaltwellenform gleichmäßig beabstandete Stromimpulse umfasst, die verschiedene Größen aufweisen, wobei die gleichmäßig beabstandeten Stromimpulse Folgendes umfassen:
Impulse, die dann, wenn der Schaltleistungsverstärker eingeschaltet ist und eine Spannung am Ansteuertransistor bei einem minimalen Pegel liegt, eine Größe entsprechend einer gewünschten Stromimpulsform aufweisen; und
Impulse, die dann, wenn der Schaltleistungsverstärker ausgeschaltet ist, eine geringe oder keine Größe aufweisen.

3. Vorrichtung nach Anspruch 1 oder 2, wobei mindestens eines der Folgenden zutrifft:
a) der Leistungsverstärker umfasst eine Kaskadenstufe in einer gemeinsamen Grundkonfiguration unter Verwendung von Halbleiterverbundmaterialien mit einer hohen Durchbruchspannung; und
der digital gesteuerte Stromausgang weist einen Strom in der Größenordnung von einigen hundert Milliampere auf;
b) wobei der Schaltleistungsverstärker einen Verstärker enthält, der eine Konfiguration der Klasse E oder F aufweist.

4. Vorrichtung nach Anspruch 1, 2 oder 3, die ferner Folgendes umfasst:
einen oder mehrere Resonatorausgangsfilter, die einem Klasse-F-Vorgang zugeordnet sind, wobei sich eine Spannungswellenform am Kollektor einer Rechteckwellenform annähert, um den zusätzlichen Leistungsverlust zu verringern.

5. Vorrichtung nach einem der vorhergehenden Ansprüche, wobei mindestens eines der Folgenden zutrifft:
a) der DAC umfasst Schaltgruppen, und die Ausgangsimpedanzsteuerung der Schalter in den Schaltgruppen ist ausgelegt, die Größen des digital gesteuerten Stromausgangs zu steuern;
b) der DAC umfasst Widerstandsgruppen, die konfigurierbar sind, auf der Basis des digitalen Ausgangs der digitalen Maschine veränderliche Größen des digital gesteuerten Stromausgangs bereitzustellen.

6. Vorrichtung nach einem der vorhergehenden Ansprüche, wobei der DAC ausgelegt ist, den Schaltleistungsverstärker bei Abwesenheit einer Strom-zu-Spannungs-Umsetzungsstufe unter Verwendung des digital gesteuerten Stromausgangs anzusteuern.

7. Vorrichtung nach einem der vorhergehenden Ansprüche, die ferner einen Grundspannungsgenerator umfasst, um für den Ansteuertransistor eine Grundspannung bereitzustellen, die eine Spannungswellenform aufweist, wobei der Grundspannungsgenerator Folgendes umfasst:
a) ein Replikationsmodul, das zum Spiegeln des digital gesteuerten Stromausgangs mit dem digital gesteuerten Stromausgang des DAC verbunden ist, und einen Spannungsregulator, der zum Erzeugen einer Grundspannung entsprechend der Spannungswellenform auf der Basis des Ausgangs des Replikationsmoduls mit dem Ausgang des Replikationsmoduls verbunden ist; oder
b) einen digitalen Signalprozessor, der zum Verarbeiten des digitalen Ausgangs mit dem digitalen Ausgang der digitalen Maschine verbunden ist, um Spannungsinformationen entsprechend der Spannungswellenform am Ausgang des digitalen Signalprozessors zu erzeugen, und einen Spannungsgenerator, der zum Erzeugen der Grundspannung auf der Basis der Spannungsinformationen mit dem Ausgang des digitalen Signalprozessors verbunden ist.

8. Vorrichtung nach einem der vorhergehenden Ansprüche, wobei die digitale Maschine Folgendes umfasst: ein digitales Aufwärtsumsetzungsmodul und/oder ein digitales Vorverzerrungs-Modul und/oder einen Impulsformer.

9. Vorrichtung nach einem der vorhergehenden Ansprüche, wobei die digitale Maschine Folgendes umfasst:
mehrere digitale Aufwärtsumsetzungsblöcke, wobei jeder der digitalen Aufwärtsumsetzungsblöcke zum Mischen einzelner Träger bei verschiedenen Frequenzen ausgelegt ist, um digitale Zwischenfrequenzen zu erzeugen.

10. Vorrichtung nach Anspruch 9, wobei die digitale Maschine ferner Folgendes umfasst:
einen Summierungsknoten zum Aufsummieren der digitalen Zwischenfrequenzen, um ein Mehrfachträgersignal zu erzeugen.

11. Vorrichtung nach Anspruch 10, wobei die digitale Maschine ferner Folgendes umfasst:
ein digitales Vorverzerrungs-Modul, das das Mehrfachträgersignal als Eingang zum Erzeugen eines vorverzerrten Signals verwendet; und
einen Impulsformer, der das vorverzerrte Signal als Eingang verwendet, um den digitalen Ausgang der digitalen Maschine zu erzeugen.

12. Funkfrequenzübertragungssystem zum Ansteuern einer Antenne, wobei die Antenne zum Übertragen von Funkfrequenzsignalen konfiguriert ist, das Folgendes umfasst:
einen Schaltleistungsverstärker zum Erzeugen der Funkfrequenzsignale, die durch die Antenne zu übertragen sind, und eine Vorrichtung nach einem der vorhergehenden Ansprüche.

13. Verfahren zum Verwenden eines oder mehrerer Digital-/Analog-Umsetzer (DAC), um durch Nullspannungsschalten den Leistungswirkungsgrad des Schaltleistungsverstärkers zu optimieren, das Folgendes umfasst:
Verarbeiten eines Basisbandsignals als Eingang durch eine digitale Maschine, wobei das Verarbeiten das Aufwärtsumsetzen des Basisbandsignals in einen digitalen Funkfrequenzausgang (HF-Ausgang) der digitalen Maschine umfasst;
Bereitstellen des digitalen HF-Ausgangs der digitalen Maschine, um einen Eingang des DAC anzusteuern;
Ausgeben eines digital gesteuerten Stromausgangs, der eine Schaltwellenform aufweist, durch den DAC; und
Ansteuern des Schaltleistungsverstärkers direkt mit dem digital gesteuerten Stromausgang des DAC, wobei der digital gesteuerte Stromausgang des DAC mit einem Emitter eines Ansteuertransistors des Schaltleistungsverstärkers verbunden ist:

14. Verfahren nach Anspruch 13, wobei:
die Schaltwellenform gleichmäßig beabstandete Stromimpulse umfasst, die verschiedene Größen aufweisen;
das Ausgeben des digital gesteuerten Stromausgangs durch den DAC Folgendes umfasst:
dann, wenn der Schaltleistungsverstärker eingeschaltet ist und eine Spannung am Ansteuertransistor bei einem minimalen Pegel liegt, Ausgeben von Impulsen, die eine Größe entsprechend einer Impulsform aufweisen; und
dann, wenn der Schaltleistungsverstärker ausgeschaltet ist, Ausgeben von Impulsen, die eine geringe oder keine Größe aufweisen.

15. Verfahren nach Anspruch 13 oder 14, wobei Folgendes zutrifft:
a) das Ausgeben des digital gesteuerten Stromausgangs durch den DAC umfasst das Ausgeben eines Stroms in der Größenordnung von einigen hundert Milliampere an den Leistungsverstärker, der eine Kascodenstufe in einer gemeinsamen Grundkonfiguration unter Verwendung von Halbleiterverbundmaterialien mit einer hohen Durchbruchspannung umfasst; und/oder
b) das direkte Ansteuern des Schaltleistungsverstärkers mit dem digital gesteuerten Stromausgang umfasst das Ansteuern des Schaltleistungsverstärkers unter Verwendung des digital gesteuerten Stromausgangs bei Abwesenheit einer Strom-zu-Spannungs-Umsetzungsstufe.

## Revendications

1. Dispositif adapté pour commander un amplificateur de puissance à commutation (703) par commutation de tension nulle, comprenant :
- un DAC *(convertisseur analogique*/*numérique)* (702) ayant une sortie courant contrôlée numériquement excitant l'amplificateur de puissance à commutation, dans lequel la sortie courant numériquement contrôlée du DAC est connectée à un émetteur d'un transistor d'excitation (704) de l'amplificateur de puissance à commutation ; et
- un moteur numérique (708) adapté pour recevoir une entrée de signal de bande de base, configuré pour convertir en élevant l'entrée de signal de bande de base en une sortie numérique radiofréquence (RF) et pour fournir la sortie numérique RF excitant une entrée du DAC pour que le DAC produise une sortie courant numériquement contrôlée ayant une forme d'onde de commutation.

2. Dispositif selon la revendication 1, dans lequel la forme d'onde de commutation comprend des impulsions de courant uniformément espacées ayant différentes magnitudes, dans lequel les impulsions de courant uniformément espacées comprennent :
- des impulsions ayant une magnitude selon une forme de pulsation de courant désirée lorsque l'amplificateur de puissance à commutation est activé et qu'une tension sur le transistor d'excitation est à un niveau minimal ; et
- des impulsions ayant une magnitude faible ou nulle lorsque l'amplificateur de puissance à commutation est désactivé.

3. Dispositif selon la revendication 1 ou 2, dans lequel au moins l'un des cas suivants s'applique :
a) l'amplificateur de puissance comprend un étage cascode dans une configuration de base commune utilisant des matériaux semi-conducteurs composés à tension de rupture élevée ; et
la sortie courant contrôlée numériquement a une intensité de l'ordre de centaines de milliampères ;
b) dans lequel l'amplificateur de puissance à commutation inclut un amplificateur ayant une configuration de classe E ou F.

4. Dispositif selon la revendication 1, 2 ou 3 comprenant en outre :
- un ou plusieurs filtres de sortie à résonateur associés à une opération de classe F, dans lequel une forme d'onde de tension au collecteur approche une forme d'onde carrée pour réduire la dissipation de puissance additionnelle.

5. Dispositif selon l'une quelconque des revendications précédentes, dans lequel au moins l'un des cas suivants s'applique :
a) le DAC comprend des réseaux de commutation, et le contrôle de l'impédance de sortie des commutateurs dans les réseaux de communication est adapté pour contrôler les magnitudes de la sortie courant numériquement contrôlée;
b) le DAC comprend des réseaux de résistances configurables pour fournir des amplitudes variables de la sortie courant numériquement contrôlée basée sur la sortie numérique du moteur numérique.

6. Dispositif selon l'une quelconque des revendications précédentes, dans lequel le DAC est adapté pour exciter l'amplificateur de puissance à commutation en utilisant la sortie courant contrôlée numériquement en l'absence d'un étage de conversion de courant en tension.

7. Dispositif selon l'une quelconque des revendications précédentes, comprenant en outre un générateur de tension de base pour fournir une tension de base pour le transistor d'excitation ayant une forme d'onde de tension, dans laquelle le générateur de tension de base comprend :
a) un module réplique connecté à la sortie courant numériquement contrôlée du DAC pour fournir un miroir de la sortie courant contrôlée numériquement et un régulateur de tension connecté à la sortie du module réplique pour générer une tension de base selon la forme d'onde de tension sur la base de la sortie du module réplique ; ou
b) un processeur de signal numérique connecté à la sortie numérique du moteur numérique pour traiter la sortie numérique pour générer des informations de tension selon la forme d'onde de tension à la sortie du processeur de signal numérique, et un générateur de tension connecté à la sortie du processeur de signal numérique pour générer la tension de base sur la base des informations de tension.

8. Dispositif selon l'une quelconque des revendications précédentes, dans lequel le moteur numérique comprend un ou plusieurs des éléments suivants : un module numérique de conversion élévatrice, un module numérique de pré-distorsion, et un formeur d'onde.

9. Dispositif selon l'une quelconque des revendications précédentes, dans lequel le moteur numérique comprend :
- une pluralité de blocs numériques de conversion élévatrice, chacun des blocs numériques de conversion élévatrice étant destiné à mélanger des porteuses individuelles à différentes fréquences pour générer des fréquences intermédiaires numériques.

10. Dispositif selon la revendication 9, dans lequel le moteur numérique comprend en outre :
- un noeud de sommation pour sommer les fréquences intermédiaires numériques pour générer un signal multi-porteuse.

11. Dispositif selon la revendication 10, dans lequel le moteur numérique comprend en outre :
- un module numérique de pré-distorsion prenant le signal multi-porteuse en entrée pour générer un signal pré-distordu ; et
- un formeur d'onde prenant le signal pré-distordu en entrée pour générer la sortie numérique du moteur numérique.

12. Système de transmetteur radiofréquence pour exciter une antenne, ladite antenne étant configurée pour transmettre des signaux de radiofréquence, comprenant :
- un amplificateur de puissance à commutation pour produire les signaux de radiofréquence devant être transmis par l'antenne, et un dispositif selon l'une quelconque des revendications précédentes.

13. Procédé d'utilisation d'un ou plusieurs convertisseurs numérique/analogique (DACs) pour optimiser l'efficacité de puissance de l'amplificateur de puissance à commutation par une commutation de tension nulle, comprenant :
- le traitement d'un signal de bande de base comme entrée d'un moteur numérique, le traitement comprenant la conversion élévatrice du signal de bande de base en sortie numérique radiofréquence (RF) du moteur numérique ;
- la fourniture de la sortie numérique RF du moteur numérique pour exciter une entrée du DAC ;
- production, par le DAC, d'une sortie courant contrôlée numériquement ayant une forme d'onde de commutation ; et
- pilotage de l'amplificateur de puissance à commutation directement avec la sortie courant numériquement contrôlée du DAC, dans lequel la sortie courant numériquement contrôlée du DAC est connectée à un émetteur d'un transistor d'excitation de l'amplificateur de puissance à commutation.

14. Procédé selon la revendication 13, dans lequel :
- la forme d'onde de commutation comprend des impulsions de courant uniformément espacées ayant différentes magnitudes ;
- la production, par le DAC, de la sortie courant numériquement contrôlée comprend :
. la production d'impulsions ayant une magnitude selon une forme d'onde lorsque l'amplificateur de puissance à commutation est activé et une tension aux bornes du transistor d'excitation est à un niveau minimal ; et
. la production d'impulsions ayant une magnitude faible ou nulle lorsque l'amplificateur de puissance de commutation est désactivé.

15. Procédé selon la revendication 13 ou la revendication 14, dans lequel au moins l'un des cas suivants s'applique :
a) la production, par le DAC, de la sortie courant numériquement contrôlée comprend la production d'un courant de l'ordre de quelques centaines de milliampères vers l'amplificateur de puissance comprenant un étage cascode dans une configuration à base commune utilisant des matériaux semi-conducteurs composés à tension de rupture élevée ;
b) l'excitation de l'amplificateur de puissance à commutation directement avec la sortie courant numériquement contrôlée comprend l'excitation de l'amplificateur de puissance à commutation en utilisant la sortie courant contrôlée numériquement en l'absence d'un étage de conversion courant en tension.
